# EUROPEAN PATENT SPECIFICATION

(11) **EP 2 270 595 B1**
(45) Date of publication and mention of the grant of the patent: **20.11.2013**
(21) Application number: 09719344.5
(22) Date of filing: 09.03.2009
(51) Int. Cl.: G03F 7/023, G03F 7/038, G03F 7/40, H01L 51/00, H05B 33/12, H05B 33/22

(54) **RADIATION-SENSITIVE RESIN COMPOSITION**
STRAHLUNGSEMPFINDLICHE HARZZUSAMMENSETZUNG
COMPOSITION DE RESINE SENSIBLE AU RAYONNEMENT

(30) Priority: 14.03.2008 JP 2008066567
(43) Date of publication of application: 05.01.2011
(73) Proprietor: Nagase ChemteX Corporation, Osaka-shi, Osaka 550-8668 (JP)
(72) Inventor: TAKEDA, Takashi, Hyogo 679-4124 (JP); KOTANI, Norihisa, Hyogo 679-4124 (JP)
(74) Representative: Vossius & Partner
(86) International application number: PCT/JP2009/054421
(87) International publication number: WO 2009/113490

(56) References cited:
- EP-A1- 1 739 485
- EP-A1- 1 818 722
- EP-A2- 0 227 487
- WO-A1-2006/008995
- JP-A- 10 293 398
- JP-A- 2004 361 638
- JP-A- 2005 181 976
- JP-A- 2006 323 089
- DATABASE WPI Week 199330 Thomson Scientific, London, GB; AN 1993-237350 XP002659819, -& JP 5 158240 A (TOYO INK MFG CO) 25 June 1993 (1993-06-25)

## Description

### TECHNICAL FIELD

The present invention relates to a radiation-sensitive resin composition with low out gas emission for forming a microstructure by radiation lithography. More specifically, the present invention relates to a radiation-sensitive resin composition which, when it is used for an insulating film of an organic electroluminescent element or the like, generates small amount of out gas after an insulating film pattern to be formed is heat-burnt and affords an insulating film which can inhibit the generation of a dark spot and pixel shrinkage, which is a degradation phenomenon of an organic electroluminescent element.

### BACKGROUND ART

Radiation-sensitive resin compositions are widely used for forming a microstructure by radiation lithography in the formation of, for example, a circuit board of a semiconductor or a liquid crystal panel. Although novolac resin-based resin compositions are widely used as radiation-sensitive resin compositions in a photoresist mask application and so on (see, for example, Patent Documents 1 and 2), the conventional novolac resin-based radiation-sensitive resin compositions emit a large amount of out gas from films after heat burning, so that pollution of light emitting elements and so on will pose a problem.

Radiation-sensitive resin compositions are used not only as photoresist masks but also as constituent components of electronic devices. Organic electroluminescent elements, for example, have been attracting attention as light emitting elements in display devices because they have such characteristics as being high in visibility as they are capable of self light emission and being excellent in impact resistance due to their being complete solid elements, however it is to be noticed that typically they include structures such as insulating films. In applications for forming insulating films or microstructures of organic electroluminescent elements, a radiation-sensitive resin film is required (1) that the cross-sectional shape of the film formed on the substrate is a normally-tapered shape, (2) that it can be heat-burnt at 230°C or lower temperatures, and (3) that less out gas is emitted from the resin film after heat burning.

Conventionally, by the use of a radiation-sensitive resin composition made from an alkali-soluble polyimide, low temperature burning has become possible.and the resin composition has been used widely for semiconductor applications or display device applications because less out gas is emitted from a coat made therefrom after heat burning (see, for example, Patent Documents 3 to 5). On the other hand, examples of using an epoxy compound or alkoxymethylated melamine as a thermally-reactive compound in the case of using a phenol resin have been reported (see, for example, Patent Documents 6 and 7). According to studies done by the present inventors, however, it has been found that a film formed by curing such a composition emits a large amount of out gas and the generated out gas damages light emitting elements or the like, causing defectives such as dark spots or pixel shrinkage.
Patent Document 1: JP 5-94013 A
Patent Document 2: JP 2001-75272 A
Patent Document 3: JP 1-60630 A
Patent Document 4: JP 3-209478 A
Patent Document 5: JP 2005-196130 A
Patent Document 6: JP 2002-169277 A
Patent Document 7: JP 2006-201653 A
EP 1 739 485 A1 discloses radiation-sensitive compositions containing a resist compound, an acid generator and an acid crosslinking agent.

### DISCLOSURE OF THE INVENTION

### PROBLEMS TO BE SOLVED BY THE INVENTION

In view of the above-described present situation, the present invention is to provide a radiation-sensitive resin composition with little out gas emission from a resin film after heat burning even when a novolac resin is used.

### MEANS FOR SOLVING THE PROBLEM

The present invention provides a radiation-sensitive resin composition containing (A) a novolac resin having repeating units represented by formula (I) given below, (B) at least one thermally-reactive compound selected from the group consisting of benzoxazine compounds, carbodiimide compounds, triazinethiol compounds, and bismaleimide compounds, (C) a radiation-sensitive compound, and (D) a solvent.

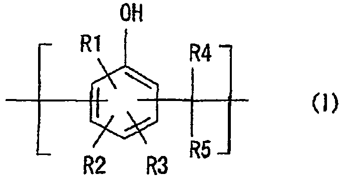

In formula (I), R1 to R3 each independently represent a hydrogen atom, a hydroxyl group, an alkoxyl group having 1 to 2 carbon atoms, or an alkyl group having 1 to 10 carbon atoms, R4 to R5 each independently represent a hydrogen atom, an alkyl group having 1 to 5 carbon atoms, or a phenyl group that may have a halogen atom, a hydroxyl group or an alkyl group having 1 to 5 carbon atoms as a substituent. Among all of the repeating units represented by formula (I) in the resin, the plurality of R1s, the plurality of R2s, the plurality of R3s, the plurality of R4s, and the plurality of R5s individually may be the same or different, provided that among all of the repeating units, at least part of the plurality of R4s and the plurality of R5s is a methyl group, a phenyl group, or a hydroxyphenyl group.

Additional embodiments are as defined in the appended claims.

### EFFECTS OF THE INVENTION

According to the present invention, it is possible to provide a radiation-sensitive resin composition which emits little out gas from a coat made therefrom after heat burning. Such a resin composition can be used suitably for microprocessing. Especially, by using the resin composition for an organic electroluminescent element, it is possible to produce an element with no fear of deterioration in performance due to out gas. Therefore, the resin composition excels particularly for radiation lithography, and especially for forming an insulating film of an organic electroluminescent element.
The radiation lithographic structure of the present invention can be processed without causing pollution to a light emitting element due to out gas generated from a film after heat burning.
The organic electroluminescent element of the present invention emits little out gas from an insulating resin film after heat burning and therefore causes no defectives such as dark spots or pixel shrinkage.

### BRIEF DESCRIPTION OF THE DRAWINGS

[Fig. 1] A graph illustrating the out gas properties of Examples 1 to 12.
[Fig. 2] A graph illustrating the out gas properties of Examples 13 to 24.
[Fig. 3] A graph illustrating the out gas properties of Comparative Examples 1 to 16.

### BEST MODES FOR CARRYING OUT THE INVENTION

The radiation-sensitive resin composition of the present invention contains (A) a novolac resin having repeating units represented by formula (I) given above. In formula (I), R1 to R3 each independently represent a hydrogen atom, a hydroxyl group, an alkoxyl group having 1 to 2 carbon atoms (methoxy or ethoxy), or an alkyl group having 1 to 10 carbon atoms, and preferably represent a hydroxyl group or an alkyl group having 1 to 4 carbon atoms (methyl, ethyl, propyl, isopropyl, butyl, sec-butyl, tert-butyl, or the like), and more preferably represent a hydroxyl group or a methyl group.

R4 and R5 each independently represent a hydrogen atom, an alkyl group having 1 to 5 carbon atoms, or a phenyl group which may have a halogen atom (a chlorine atom, or the like), a hydroxyl group or an alkyl group having 1 to 5 carbon atoms as a substituent. Among all of the repeating units represented by formula (I) in the novolac resin (A), at least part of the plurality of R4s and the plurality of R5s is a methyl group, a phenyl group, or a hydroxyphenyl group. Preferably, in the novolac resin (A), the proportion of the repeating units in which R4 and/or R5 is a methyl group, a phenyl group, or a hydroxyphenyl group is 20 to 100%.

In the novolac resin (A), among all of the repeating units represented by formula (I), the plurality of R1s, the plurality of R2s, the plurality of R3s, the plurality of R4s, and the plurality of R5s individually may be the same or different.

The novolac resin (A) to be used in the present invention can be obtained by making a phenol react with an aldehyde or a ketone in the presence of an acidic catalyst (e.g., oxalic acid or p-toluenesulfonic acid).

Examples of the phenol include phenol, o-cresol, m-cresol, p-cresol, 2,3-xylenol, 2,4-xylenol, 2,5-xylenol, 2,6-xylenol, 3,4-xylenol, 3,5-xylenol, 2,3,5-trimethylphenol, 2,3,6-trimethylphenol, 2-tert-butylphenol, 3-tert-butylphenol, 4-tert-butylphenol, 2-methylresorcinol, 4-methylresorcinol, 5-methylresorcinol, 4-tert-butylcatechol, 2-methoxyphenol, 3-methoxyphenol, 2-propylphenol, 3-propylphenol, 4-propylphenol, 2-isopropylphenol, 2-methoxy-5-methylphenol, 2-tert-butyl-5-methylphenol, and pyrogallol. These may be used solely or two or more of them may be used in combination.

In the present invention, in view of the performance of an insulating film to be obtained, it is preferable to use, as the phenol, pyrogallol or m-cresol and another phenol, e.g., at least one phenol selected from among p-cresol, 2,4-xylenol, 2,5-xylenol, and 3,5-xylenol, in combination. In this case, the weight ratio of used amount of m-cresol to another phenol is preferably from 25 : 75 to 85 : 15, more preferably from 30 : 70 to 70 : 30.

Examples of the aldehyde include formaldehyde, formalin, paraformaldehyde, acetaldehyde, propionaldehyde, benzaldehyde, phenylacetaldehyde, α-phenylpropionaldehyde, β-phenylpropionaldehyde, o-hydroxybenzaldehyde, m-hydroxybenzaldehyde, p-hydroxybenzaldehyde, o-chlorobenzaldehyde, m-chlorobenzaldehyde, p-chlorobenzaldehyde, o-methylbenzaldehyde, m-methylbenzaldehyde, p-methylbenzaldehyde, p-ethylbenzaldehyde, p-n-butylbenzaldehyde, and terephthalaldehyde. Examples of the ketone include acetone, methyl ethyl ketone, diethyl ketone, and diphenyl ketone. These may be used solely or two or more of them may be used in combination.

In the present invention, it is preferable to combine, as an aldehyde or a ketone, acetone or benzaldehyde with formaldehyde or hydroxybenzaldehyde, e.g., o-hydroxybenzaldehyde, m-hydroxybenzaldehyde, or p-hydroxybenzaldehyde. In this case, the ratio of used amount of acetone or benzaldehyde to formaldehyde or hydroxybenzaldehyde, expressed by the weight ratio of acetone or benzaldehyde : formaldehyde or hydroxybenzaldehyde, is preferably from 0 : 100 to 100 : 0, and more preferably from 20 : 80 to 80 : 20.

The novolac resin (A) to be used in the present invention can be obtained by making the above-described phenol react with the above-described aldehyde or ketone by a conventional method in the presence of an acidic catalyst, such as oxalic acid or p-toluenesulfonic acid. It is noted that since the requirement that among all of the repeating units represented by formula (I), at least part of the plurality of R4s and the plurality of R5s is a methyl group, a phenyl group, or a hydroxyphenyl group is not satisfied when a compound in which R4 and R5 will become only hydrogen atoms after reaction (e.g., formaldehyde) is used solely, it is necessary to use in combination at least one compound in which at least part of the plurality of R4s and the plurality of R5s can become a methyl group, a phenyl group, or a hydroxyphenyl group (e.g., corresponding aldehydes among those listed above).

The radiation-sensitive resin composition of the present invention contains the thermally-reactive compound (B) in order to cure a coat by heat burning. The thermally-reactive compounds (B) to be used in the composition of the present invention is at least one compound selected from the group consisting of benzoxazine compounds, carbodiimide compounds, triazinethiol compounds, and bismaleimide compounds. Triazinethiol compounds and bismaleimide compounds are preferable.

The benzoxazine compounds are not restricted particularly and compounds (monomers, oligomers, or polymers) having a benzoxazine ring can be used. Examples thereof include the compounds disclosed in JP 2006-335671 A and commercially available products can also be used.

The carbodiimide compounds are not restricted particularly and compounds having a carbodiimide group can be used. Moreover, commercially available products can also be used. For example, the products of the series of Carbodilite (commercial name, produced by Nisshinbo Chemical Inc.) can be used.

Examples of the triazinethiol compounds include 2,4,6-trithiol-1,3,5-triazine, 2-dimethylamino-4,6-dithiol-1,3,5-triazine, 2-dibutylamino-4,6-dithiol-1,3,5-triazine, 2-phenylamino-4,6-dithiol-1,3,5-triazine.

The bismaleimide compounds are not restricted particularly, and commercially available products can also be used. Examples thereof include the products of the series of BMI (commercial name, produced by Daiwakasei Industry Co., Ltd.).

In the composition of the present invention, the incorporated amount of the thermally-reactive compound (B) is preferably 0.1 to 15 parts by weight, and more preferably 0.5 to 10 parts by weight relative to 100 parts by weight of the novolac resin (A) from the viewpoint of alkali solubility.

The radiation-sensitive resin composition of the present invention may be made into either a composition for positive type radiation lithography or a composition for negative type radiation lithography.

In a composition for positive type radiation lithography, it is preferable to use a naphthoquinonediazide sulfonic acid ester as the radiation-sensitive compound (C). A compound resulting from whole or partial esterification of the hydroxyl groups of a polyhydric phenol with 1,2-quinone diazide sulfonic acid can be used as the naphthoquinonediazide sulfonic acid ester. Specifically, a compound resulting from esterification of 20 to 100% of the hydroxyl groups of a polyhydric phenol with 1,2-quinone diazide sulfonic acid can be used.

Examples of the esterified quinone diazide include (c.1) an esterification product of trihydroxybenzophenone with 1,2-naphthoquinonediazide sulfonic acid, (c.2) an esterification product of tetrahydroxybenzophenone with 1,2-naphthoquinonediazide sulfonic acid, (c.3) an esterification product of pentahydroxybenzophenone with 1,2-naphthoquinonediazide sulfonic acid, (c.4) an esterification product of hexahydroxybenzophenone with 1,2-naphthoquinonediazide sulfonic acid, (c.5) an esterification product of bis(2,4'-dihydroxyphenyl)methane with 1,2-naphthoquinonediazide sulfonic acid, (c.6) an esterification product of bis(p-hydroxyphenyl)methane with 1,2-naphthoquinonediazide sulfonic acid, (c.7) an esterification product of tri(p-hydroxyphenyl)methane with 1,2-naphthoquinonediazide sulfonic acid, (c.8) an esterification product of 1,1,1-tri(p-hydroxyphenyl)ethane with 1,2-naphthoquinonediazide sulfonic acid, (c.9) an esterification product of bis(2,3,4-trihydroxyphenyl)methane with 1,2-naphthoquinonediazide sulfonic acid, (c.10) an esterification product of 2,2-bis(2,3,4-trihydroxyphenyl)propane with 1,2-naphthoquinonediazide sulfonic acid, (c.11) an esterification product of 1,1,3-tris(2,5-dimethyl-4-hydroxyphenyl)-3-phenylpropane with 1,2-naphthoquinonediazide sulfonic acid, (c.12) an esterification product of 4,4'-[1-[4-[1-[4-hydroxyphenyl]-1-methylethyl]phenyl]ethyli dene]bisphenol with 1,2-naphthoquinonediazide sulfonic acid, and (c.13) an esterification product of bis(2,5-dimethyl-4-hydroxyphenyl)-2-hydroxyphenylmethane with 1,2-naphthoquinonediazide sulfonic acid.

(c.1) Esterification product of trihydroxybenzophenone with 1,2-naphthoquinonediazide sulfonic acid: specific examples include
2,3,4-trihydroxybenzophenone-1,2-naphthoquinonediazide-4-su lfonic acid ester,
2,3,4-trihydroxybenzophenone-1,2-naphthoquinonediazide-5-su lfonic acid ester,
2,4,6-trihydroxybenzophenone-1,2-naphthoquinonediazide-4-su lfonic acid ester, and
2,4,6-trihydroxybenzophenone-1,2-naphthoquinonediazide-5-su lfonic acid ester.

(c.2) Esterification product of
tetrahydroxybenzophenone with 1,2-naphthoquinonediazide sulfonic acid: specific examples include
2,2',4,4'-tetrahydroxybenzophenone-1,2-naphthoquinonediazid e-4-sulfonic acid ester,
2,2',4,4'-tetrahydroxybenzophenone-1,2-naphthoquinonediazid e-5-sulfonic acid ester,
2,3,4,3'-tetrahydroxybenzophenone-1,2-naphthoquinonediazide -4-sulfonic acid ester,
2,3,4,3'-tetrahydroxybenzophenone-1,2-naphthoquinonediazide -5-sulfonic acid ester,
2,3,4,4'-tetrahydroxybenzophenone-1,2-naphthoquinonediazide -4-sulfonic acid ester,
2,3,4,4'-tetrahydroxybenzophenone-1,2-naphthoquinonediazide -5-sulfonic acid ester,
2,3,4,2'-tetrahydroxy-4'-methylbenzophenone-1,2-naphthoquin onediazide-4-sulfonic acid ester,
2,3,4,2'-tetrahydroxy-4'-methylbenzophenone-1,2-naphthoquin onediazide-5-sulfonic acid ester,
2,3,4,4'-tetrahydroxy-3'-methoxybenzophenone-1,2-naphthoqui nonediazide-4-sulfonic acid ester, and
2,3,4,4'-tetrahydroxy-3'-methoxybenzophenone-1,2-naphthoqui nonediazide-5-sulfonic acid ester.

(c.3) Esterification product of
pentahydroxybenzophenone with 1,2-naphthoquinonediazide sulfonic acid: specific examples include
2,3,4,2',6'-pentahydroxybenzophenone-1,2-naphthoquinonediaz ide-4-sulfonic acid ester, and
2,3,4,2',6'-pentahydroxybenzophenone-1,2-naphthoquinonediaz ide-5-sulfonic acid ester.

(c.4) Esterification product of hexahydroxybenzophenone with 1,2-naphthoquinonediazide sulfonic acid: specific examples include
2,4,6,3',4',5'-hexahydroxybenzophenone-1,2-naphthoquinonedi azide-4-sulfonic acid ester,
2,4,6,3',4',5'-hexahydroxybenzophenone-1,2-naphthoquinonedi azide-5-sulfonic acid ester,
3,4,5,3',4',5'-hexahydroxybenzophenone-1,2-naphthoquinonedi azide-4-sulfonic acid ester, and
3,4,5,3',4',5'-hexahydroxybenzophenone-1,2-naphthoquinonedi azide-5-sulfonic acid ester.

(c.5) Esterification product of
bis(2,4'-dihydroxyphenyl)methane with
1,2-naphthoquinonediazide sulfonic acid: specific examples include
bis(2,4'-dihydroxyphenyl)methane-1,2-naphthoquinonediazide-4-sulfonic acid ester, and
bis(2,4'-dihydroxyphenyl)methane-1,2-naphthoquinonediazide-5-sulfonic acid ester.

(c.6) Esterification product of
bis(p-hydroxyphenyl)methane with 1,2-naphthoquinonediazide sulfonic acid: specific examples include
bis(p-hydroxyphenyl)methane-1,2-naphthoquinonediazide-4-sul fonic acid ester, and
bis(p-hydroxyphenyl)methane-1,2-naphthoquinonediazide-5-sul fonic acid ester.

(c.7) Esterification product of
tri(p-hydroxyphenyl)methane with 1,2-naphthoquinonediazide sulfonic acid: specific examples include
tri(p-hydroxyphenyl)methane-1,2-naphthoquinonediazide-4-sul fonic acid ester, and
tri(p-hydroxyphenyl)methane-1,2-naphthoquinonediazide-5-sul fonic acid ester.

(c.8) Esterification product of
1,1,1-tri(p-hydroxyphenyl)ethane with
1,2-naphthoquinonediazide sulfonic acid: specific examples include
1,1,1-tri(p-hydroxyphenyl)ethane-1,2-naphthoquinonediazide-4-sulfonic acid ester, and
1,1,1-tri(p-hydroxyphenyl)ethane-1,2-naphthoquinonediazide-5-sulfonic acid ester.

(c.9) Esterification product of
bis(2,3,4-trihydroxyphenyl)methane with
1,2-naphthoquinonediazide sulfonic acid: specific examples include
bis(2,3,4-trihydroxyphenyl)methane-1,2-naphthoquinonediazid e-4-sulfonic acid ester, and
bis(2,3,4-trihydroxyphenyl)methane-1,2-naphthoquinonediazid e-5-sulfonic acid ester.

(c.10) Esterification product of
2,2-bis(2,3,4-trihydroxyphenyl)propane with
1,2-naphthoquinonediazide sulfonic acid: specific examples include
2,2-bis(2,3,4-trihydroxyphenyl)propane-1,2-naphthoquinonedi azide-4-sulfonic acid ester, and
2,2-bis(2,3,4-trihydroxyphenyl)propane-1,2-naphthoquinonedi azide-5-sulfonic acid ester.

(c.11) Esterification product of
1,1,3-tris(2,5-dimethyl-4-hydroxyphenyl)-3-phenylpropane with 1,2-naphthoquinonediazide sulfonic acid: specific examples include
1,1,3-tris(2,5-dimethyl-4-hydroxyphenyl)-3-phenylpropane-1, 2-naphthoquinonediazide-4-sulfonic acid ester, and
1,1,3-tris(2,5-dimethyl-4-hydroxyphenyl)-3-phenylpropane-1, 2-naphthoquinonediazide-5-sulfonic acid ester.

(c.12) Esterification product of
4,4'-[1-[4-[1-[4-hydroxyphenyl]-1-methylethyl]phenyl]ethyli dene]bisphenol with 1,2-naphthoquinonediazide sulfonic acid: specific examples include
4,4'-[1-[4-[1-[4-hydroxyphenyl]-1-methylethyl]phenyl]ethyli dene]bisphenol-1,2-naphthoquinonediazide-4-sulfonic acid ester, and
4,4'-[1-[4-[1-[4-hydroxyphenyl]-1-methylethyl]phenyl]ethyli dene]bisphenol-1,2-naphthoquinonediazide-5-sulfonic acid ester.

(c.13) Esterification product of bis(2,5-dimethyl-4-hydroxyphenyl)-2-hydroxyphenylmethane with 1,2-naphthoquinonediazide sulfonic acid: specific examples include
bis(2,5-dimethyl-4-hydroxyphenyl)-2-hydroxyphenylmethane-1, 2-naphthoquinonediazide-4-sulfonic acid ester, and
bis(2,5-dimethyl-4-hydroxyphenyl)-2-hydroxyphenylmethane-1, 2-naphthoquinonediazide-5-sulfonic acid ester.

Moreover, other quinonediazide group-containing compounds, e.g., orthobenzoquinonediazide, orthonaphthoquinonediazide, orthoanthraquinonediazide, and orthonaphthoquinonediazide sulfonic acid esters, and their nucleus-substituted derivatives; and reaction products of orthonaphthoquinonesulfonyl chloride with compounds having a hydroxyl group or an amino group, can also be used. Examples of the compounds having a hydroxyl group or an amino group include phenol, p-methoxyphenol, dimethylphenol, hydroquinone, bisphenol A, naphthol, carbinol, pyrocatechol, pyrogallol, pyrogallol monomethyl ether, pyrogallol 1,3-dimethyl ether, gallic acid, gallic acid esterified or etherified with its hydroxyl groups partly remaining, aniline, and p-aminodiphenylamine.

Among these are preferably used
2,3,4-trihydroxybenzophenone-1,2-naphthoquinonediazide-4-su lfonic acid ester,
2,3,4-trihydroxybenzophenone-1,2-naphthoquinonediazide-5-su lfonic acid ester,
2,3,4,4'-tetrahydroxybenzophenone-1,2-naphthoquinonediazide -4-sulfonic acid ester,
2,3,4,4'-tetrahydroxybenzophenone-1,2-naphthoquinonediazide -5-sulfonic acid ester,
1,1,3-tris(2,5-dimethyl-4-hydroxyphenyl)-3-phenylpropane-1, 2-naphthoquinonediazide-4-sulfonic acid ester,
1,1,3-tris(2,5-dimethyl-4-hydroxyphenyl)-3-phenylpropane-1, 2-naphthoquinonediazide-5-sulfonic acid ester,
4,4'-[1-[4-[1-[4-hydroxyphenyl]-1-methylethyl]phenyl]ethyli dene]bisphenol-1,2-naphthoquinonediazide-4-sulfonic acid ester, and
4,4'-[1-[4-[1-[4-hydroxyphenyl]-1-methylethyl]phenyl]ethyli dene]bisphenol-1,2-naphthoquinonediazide-5-sulfonic acid ester. Moreover, regarding these quinonediazide compounds, two or more compounds may be used in combination.

1,2-Quinonediazide sulfonic acid esters like those described above can be obtained, for example, by esterifying a halide of 1,2-quinonediazide sulfonic acid with a corresponding polyhydric phenol (polyvalent hydroxy compound) in the presence of a base catalyst.

More specifically, for example, the above-described 2,3,4,4'-tetrahydroxybenzophenone-1,2-naphthoquinonediazide -5-sulfonic acid ester is obtained by condensing 2,3,4,4'-tetrahydroxybenzophenone and 1,2-quinonediazide-5-sulfonic acid chloride.

In a composition for positive type radiation lithography, although the incorporated amount of the radiation-sensitive compound (C) varies depending upon the compound to be used, it is preferably 1 to 30 parts by weight, and more preferably 10 to 25 parts by weight relative to 100 parts by weight of the novolac resin (A), in the case of a naphthoquinonediazide sulfonic acid ester, for example.

In a composition for negative type radiation lithography, a photoacid generator that generates an acid by the action of radiation, such as onium salts, halogen-containing compounds, diazomethane compounds, sulfone compounds, alkyl (C₁₋₁₂) sulfonic acid esters, haloalkyl (C₁₋₁₂) sulfonic acid esters, arylsulfonic acid esters, and iminosulfonate can be used as the radiation-sensitive compound (C). Examples of the onium salts include iodonium salts, sulfonium salts, diazonium salts, ammonium salts, and pyridinium salts of triflate or hexaflate, and examples of the halogen-containing compounds include haloalkyl group-containing hydrocarbon compounds or haloalkyl group-containing heterocyclic compounds, e.g., (trichloromethyl)-s-triazine derivatives, such as phenyl-bis(trichloromethyl)-s-triazine and methoxyphenyl-bis(trichloromethyl)-s-triazine, bromine compounds, such as tribromoneopentyl alcohol and hexabromohexane, and iodine compounds, such as hexaiodohexane. Examples of the diazomethane compounds include bis(trifluoromethylsulfonium)diazomethane and bis(cyclohexylsulfonium)diazomethane. Examples of the sulfone compounds include β-ketosulfone and β-sulfonyl sulfone. These photoacid generators may be used singly or as a mixture of two or more of them.

In a composition for negative type radiation lithography, the incorporated amount of the radiation-sensitive compound (C), which varies depending upon the compound to be used, is preferably 0.1 to 10 parts by weight, and more preferably 0.5 to 5.0 parts by weight relative to 100 parts by weight of the novolac resin (A).

The radiation-sensitive resin composition of the present invention is dissolved in a solvent (D) and used in a state of solution. For example, a radiation-sensitive resin composition in a state of solution can be prepared by dissolving a novolac resin (A) in a solvent (D) and mixing a thermally-reactive compound (B), a radiation-sensitive compound (C) and, as necessary, a surfactant (E) or a colorant (F), such as a dye or a pigment, in prescribed proportions, just before use.

Examples of the solvent (D) include alcohols, such as methanol and ethanol; ethers, such as tetrahydrofuran; glycol ethers, such as ethylene glycol monomethyl ether, ethylene glycol dimethyl ether, ethylene glycol methyl ethyl ether, and ethylene glycol monoethyl ether; ethylene glycol alkyl ether acetates, such as methylcellosolve acetate and ethylcellosolve acetate; diethylene glycols, such as diethylene glycol monomethyl ether, diethylene glycol diethyl ether, diethylene glycol dimethyl ether, diethylene glycol ethyl methyl ether, diethylene glycol monoethyl ether, and diethylene glycol monobutyl ether; propylene glycol alkyl ether acetates, such as propylene glycol methyl ether acetate and propylene glycol ethyl ether acetate; aromatic hydrocarbons, such as toluene and xylene; ketones, such as methyl ethyl ketone, methyl amyl ketone, cyclohexanone, and 4-hydroxy-4-methyl-2-pentanone; and esters, such as ethyl 2-hydroxypropionate, methyl 2-hydroxy-2-methylpropionate, ethyl 2-hydroxy-2-methylpropionate, ethyl ethoxyacetate, ethyl hydroxyacetate, methyl 2-hydroxy-2-methylbutanoate, methyl 3-methoxypropionate, ethyl 3-methoxypropionate, methyl 3-ethoxypropionate, ethyl 3-ethoxypropionate, ethyl acetate, butyl acetate, methyl lactate, and ethyl lactate.

Among these are preferred glycol ethers, alkylene glycol alkyl ether acetates, diethylene glycol dialkyl ethers, and diethylene glycols. Ethyl 3-ethoxypropionate, ethyl lactate, propylene glycol monomethyl ether acetate, ethylene glycol monoethyl ether acetate, methyl amyl ketone, and diethylene glycol ethyl methyl ether are more preferred. Such solvents may be used singly or two or more of them may be combined.

The radiation-sensitive resin composition of the present invention may contain a surfactant (E) as an optional component in addition to the above-described essential components in order to prevent striations (application streaks) to improve application property or in order to improve the developability of a coat, for example.

Examples of such a surfactant (E) include nonionic surfactants, e.g., polyoxyethylene alkyl ethers, such as polyoxyethylene lauryl ether, polyoxyethylene stearyl ether, and polyoxyethylene oleyl ether; polyoxyethylene aryl ethers, such as polyoxyethylene octylphenyl ether and polyoxyethylene nonylphenyl ether; and polyoxyethylene dialkyl esters, such as polyoxyethylene dilaurate and polyoxyethylene distearate; fluorine-based surfactants, e.g., F-TOP EF301, 303, 352 (commercial names, produced by Shin Akita Kasei K.K.), MEGAFAC F171, F172, F173, R-08, R-30 (commercial names, produced by DIC Corporation), Fluorad FC-430, FC-431 (commercial names, produced by Sumitomo 3M Ltd.), AsahiGuard AG710, Surflon S-382, SC-101, SC-102, SC-103, SC-104, SC-105, SC-106 (commercial names, produced by Asahi Glass Co., Ltd.); an organosiloxane polymer KP341 (commercial name, produced by Shin-Etsu Chemical Co., Ltd.); and (meth)acrylic acid-based copolymers PolyFlow Nos. 57 and 95 (commercial names, produced by Kyoeisha Chemical Co., Ltd.). Two or more of these may be used together.

Such a surfactant is incorporated in an amount of 2 parts by weight or less, preferably 1 part by weight or less relative to 100 parts by weight of the radiation-sensitive resin composition.

Moreover, the radiation-sensitive resin composition of the present invention may contain a colorant (F), such as a dye or a pigment, as an optional component.

The colorant (F), such as a dye or a pigment, may be either an inorganic pigment or an organic pigment.

The composition of the present invention is prepared by using the above-described solvent (D). Although an appropriate solid concentration can be used depending upon the intended purpose of use of the composition, the solid concentration may be adjusted to 10 to 50% by weight, for example. The composition liquid prepared as described above is usually filtered before use. Examples of the means of the filtration include a Millipore Filter having a pore diameter of 0.05 to 1.0 µm.

The radiation-sensitive resin composition solution of the present invention prepared in such a way is excellent also in terms of long-term storage stability.

When the composition of the present invention is used for radiation lithography, a coat can be formed by first applying the radiation-sensitive resin composition of the present invention to the surface of a substrate, and then removing the solvent by a means such as heating. The method for applying the radiation-sensitive resin composition to the surface of the substrate is not particularly restricted, and various methods, such as a spray method, a roll coating method, a slit method, and a spin-coating method, can be used.

Subsequently, the coat is usually heated (prebaked). Although the heating conditions vary depending, for example, upon the kinds and the compounded ratios of the components, a coat can be obtained usually by performing heat treatment at 70 to 120°C for a prescribed time, for example, for 1 to 10 minutes on a hot plate or for 10 to 30 minutes in an oven.

Next, a prescribed patterned coat is formed by applying radiation (for example, ultraviolet rays, far-ultraviolet rays, X-rays, electron beams, gamma rays, or synchrotron radiation) to the prebaked coat through a prescribed patterned mask, performing development with a developer, and removing unnecessary portions. As the developer can be used aqueous solutions of alkalies, e.g., inorganic alkalies, such as sodium hydroxide, potassium hydroxide, sodium carbonate, sodium silicate, sodium metasilicate, and ammonia water; primary amines, such as ethylamine and n-propylamine; secondary amines, such as diethylamine and di-n-propylamine; tertiary amines, such as triethylamine and methyldiethylamine; alcoholamines, such as dimethylethanolamine and triethanolamine; quaternary ammonium salts, such as tetramethylammonium hydroxide, tetraethylammonium hydroxide, and choline; cyclic amines, such as pyrrole, piperidine, 1,8-diazabicyclo[5,4,0]-7-undecene, and 1,5-diazabicyclo[4,3,0]-5-nonane.

Moreover, an aqueous solution prepared by adding, to the aqueous alkali solution, an appropriate amount of a water-soluble organic solvent, such as methanol or ethanol, a surfactant, and so on can be used as a developer. The developing time is usually 30 to 180 seconds, and the method of development may be any method, e.g., a puddle method, a shower method, or a dipping method. After the development, a pattern is formed by performing running water washing for 30 to 90 seconds to remove unnecessary portions and drying the resultant with compressed air or compressed nitrogen with blowing. After that, a cured coat can be obtained by subjecting the pattern to heat treatment by using a heating apparatus, such as a hot plate or an oven, at a prescribed temperature, for example, 150 to 250°C, for a prescribed time, for example, for 2 to 30 minutes on a hot plate or for 30 to 90 minutes in an oven.

The composition of the present invention can be suitably used as a positive type radiation-sensitive resin for forming an insulating film of an organic electroluminescent element and also can be used as a negative type radiation-sensitive resin composition for electronic component lithography.

### EXAMPLES

The present invention is illustrated concretely on the basis of examples and comparative examples, but the present invention as defined by the appended claims is not limited to the examples. In the following examples and comparative examples, "part" means "part by weight."

### Examples 1 to 24, Comparative Examples 1 to 16

### (1) Novolac resins 1 to 6

Novolac resins (resin 1 to resin 6) were prepared in the compounded ratios given in Table 1.

**[Table 1]**

| | Phenol | | Aldehyde or ketone | | Molecular weight |
|---|---|---|---|---|---|
| Resin 1 | m-Cresol 60% by weight | p-Cresol 40% by weight | Formaldehyde 100% by weight | | 1600 |
| Resin 2 | m-Cresol 60% by weight | p-Cresol 40% by weight | Formaldehyde 80% by weight | o-Hydroxybenzaldehyde 20% by weight | 1800 |
| Resin 3 | m-Cresol 60% by weight | p-Cresol 40% by weight | Benzaldehyde 100% by weight | | 1400 |
| Resin 4 | m-Cresol 60% by weight | p-Cresol 40% by weight | o-Hydroxybenzaldehyde 100% by weight | | 1800 |
| Resin 5 | m-Cresol 60% by weight | p-Cresol 40% by weight | Benzaldehyde 60% by weight | o-Hydroxybenzaldehyde 40% by weight | 1300 |
| Resin 6 | Pyrogallol 100% by weight | | Acetone 100% by weight | | 1700 |

The resins given in Table 1 respectively represent, in formula (A),
Resin 1: R1 to R3 = H, H, methyl, R4, R5 = H;
Resin 2: R1 to R3 = H, H, methyl, R4, R5 = H, phenyl;
Resin 3: R1 to R3 = H, H, methyl, R4, R5 = phenyl;
Resin 4: R1 to R3 = H, H, methyl, R4, R5 = hydroxyphenyl;
Resin 5: R1 to R3 = H, H, methyl, R4, R5 = phenyl, hydroxyphenyl; and
Resin 6: R1 to R3 = OH, R4, R5 = methyl.

### (2) Preparation of radiation-sensitive resin composition

Radiation-sensitive resin compositions were prepared in compounded amounts (parts) given in Table 2. The meanings of the abbreviations given in the table are as follows.
Resins 1 to 6: The novolac resins prepared in (1) described above (Resin 1 to Resin 6)
Benzoxazine compound: bisphenol A type benzoxazine
Carbodiimide compound: bis(2,6-diisopropylphenyl)carbodiimide
Triazinethiol compound: 2,4,6-trithiol-1,3,5-triazine
Bismaleimide compound: 4,4'-diphenylmethanebismaleimide
Methylated melamine compound: Methylated melamine produced by Sanwa Chemical Co., Ltd.
Epoxy compound: bisphenol type epoxy resin produced by Nippon Kayaku Co., Ltd.
Quinonediazide compound: 2,3,4,4'-tetrahydroxybenzophenone-1,2-naphthoquinonediazide -5-sulfonic acid ester
Photoacid generator: 2-(p-methoxystyryl)-4,6-bis(trichloromethyl)-s-triazine

**[Table 2]**

| | (A) Component (parts) | | (B) Component (parts) | | (C) Component (parts) | |
|---|---|---|---|---|---|---|
| Example 1 | Resin 2 | 100 | Benzoxazine compound | 5 | Quinonediazide compound | 20 |
| Example 2 | | 100 | Carbodiimide compound | 5 | Quinonediazide compound | 20 |
| Example 3 | | 100 | Triazinethiol compound | 5 | Quinonediazide compound | 20 |
| Example 4 | | 100 | Bismaleimide compound | 5 | Quinonediazide compound | 20 |
| Example 5 | Resin 3 | 100 | Benzoxazine compound | 5 | Quinonediazide compound | 20 |
| Example 6 | | 100 | Carbodiimide compound | 5 | Quinonediazide compound | 20 |
| Example 7 | | 100 | Triazinethiol compound | 5 | Quinonediazide compound | 20 |
| Example 8 | | 100 | Bismaleimide compound | 5 | Quinonediazide compound | 20 |
| Example 9 | Resin 4 | 100 | Benzoxazine compound | 5 | Quinonediazide compound | 20 |
| Example 10 | | 100 | Carbodiimide compound | 5 | Quinonediazide compound | 20 |
| Example 11 | | 100 | Triazinethiol compound | 5 | Quinonediazide compound | 20 |
| Example 12 | | 100 | Bismaleimide compound | 5 | Quinonediazide compound | 20 |
| Example 13 | Resin 5 | 100 | Benzoxazine compound | 5 | Quinonediazide compound | 20 |
| Example 14 | | 100 | Carbodiimide compound | 5 | Quinonediazide compound | 20 |
| Example 15 | | 100 | Triazinethiol compound | 5 | Quinonediazide compound | 20 |
| Example 16 | | 100 | Bismaleimide compound | 5 | Quinonediazide compound | 20 |
| Example 17 | Resin 6 | 100 | Benzoxazine compound | 5 | Quinonediazide compound | 20 |
| Example 18 | | 100 | Carbodiimide compound | 5 | Quinonediazide compound | 20 |
| Example 19 | | 100 | Triazinethiol compound | 5 | Quinonediazide compound | 20 |
| Example 20 | | 100 | Bismaleimide compound | 5 | Quinonediazide compound | 20 |
| Example 21 | Resin 5 | 100 | Benzoxazine compound | 5 | Photoacid generator | 3 |
| Example 22 | | 100 | Carbodiimide compound | 5 | Photoacid generator | 3 |
| Example 23 | | 100 | Triazinethiol compound | 5 | Photoacid generator | 3 |
| Example 24 | | 100 | Bismaleimide compound | 5 | Photoacid generator | 3 |
| Comparative Example 1 | Resin 1 | 100 | Methylated melamine compound | 5 | Quinonediazide compound | 20 |
| Comparative Example 2 | | 100 | Epoxy compound | 5 | Quinonediazide compound | 20 |
| Comparative Example 3 | | 100 | Benzoxazine compound | 5 | Quinonediazide compound | 20 |
| Comparative Example 4 | | 100 | Carbodiimide compound | 5 | Quinonediazide compound | 20 |
| Comparative Example 5 | | 100 | Triazinedithiol compound | 5 | Quinonediazide compound | 20 |
| Comparative Example 6 | | 100 | Bismaleimide compound | 5 | Quinonediazide compound | 20 |
| Comparative Example 7 | Resin 2 | 100 | Methylated melamine compound | 5 | Quinonediazide compound | 20 |
| Comparative Example 8 | | 100 | Epoxy compound | 5 | Quinonediazide compound | 20 |
| Comparative Example 9 | Resin 3 | 100 | Methylated melamine compound | 5 | Quinonediazide compound | 20 |
| Comparative Example 10 | | 100 | Epoxy compound | 5 | Quinonediazide compound | 20 |
| Comparative Example 11 | Resin 4 | 100 | Methylated melamine compound | 5 | Quinonediazide compound | 20 |
| Comparative Example 12 | | 100 | Epoxy compound | 5 | Quinonediazide compound | 20 |
| Comparative Example 13 | Resin 5 | 100 | Methylated melamine compound | 5 | Quinonediazide compound | 20 |
| Comparative Example 14 | | 100 | Epoxy compound | 5 | Quinonediazide compound | 20 |
| Comparative Example 15 | Resin 6 | 100 | Methylated melamine compound | 5 | Quinonediazide compound | 20 |
| Comparative Example 16 | | 100 | Epoxy compound | 5 | Quinonediazide compound | 20 |

Solutions of radiation-sensitive resin compositions were prepared respectively by dissolving the compounded materials given in Table 2 in propylene glycol monomethyl ether acetate so that the solid concentration might become 30% by weight, followed by filtration with a Millipore filter of 0. 5 µm in pore diameter.

### (3) Formation of a pattern

A solution of a radiation-sensitive resin composition obtained in each example or comparative example was applied to a 5-inch silicon substrate with a spinner and then was prebaked at 100°C for 90 seconds on a hot plate, so that a coat with a thickness of 1.8 µm was formed. The resulting coat was exposed to light by using a stepper, NSR 1505g4C manufactured by Nikon Corporation (NA = 0.42, λ = 436 nm) and then was developed by a puddle method at 23°C for 60 seconds with an aqueous tetramethylammonium hydroxide (TMAH) solution. Then, the coat was washed with running water and dried, so that a pattern was formed on a wafer. Moreover, for the positive type radiation-sensitive compositions (Examples 1 to 20 and Comparative Examples 1 to 16), the resulting pattern was observed by a microscope and the amount of light exposure at which no residual coat was observed in a space part in a 50-µm line and a space pattern was defined as a sensitivity. On the other hand, for the negative type radiation-sensitive resin compositions (Examples 21 to 24), only whether there is a pattern or not was checked by microscopic observation because the above-described evaluation could not be performed.

### (4) Preparation of substrate for out gas measurement

A solution of a radiation-sensitive resin composition obtained in each example or comparative example was applied to a 5-inch silicon substrate with a spinner and then was prebaked at 100°C for 90 seconds on a hot plate, so that a coat with a thickness of 1.8 µm was formed. The resulting coat was developed by a puddle method at 23°C for 60 seconds with a 2.38 wt% aqueous tetramethylammonium hydroxide (TMAH) solution without being subjected to light exposure. Then, the coat was washed with running water, dried, and then burnt in an oven at 230°C for 60 minutes to yield a sample for evaluation.

### (5) Out gas measurement

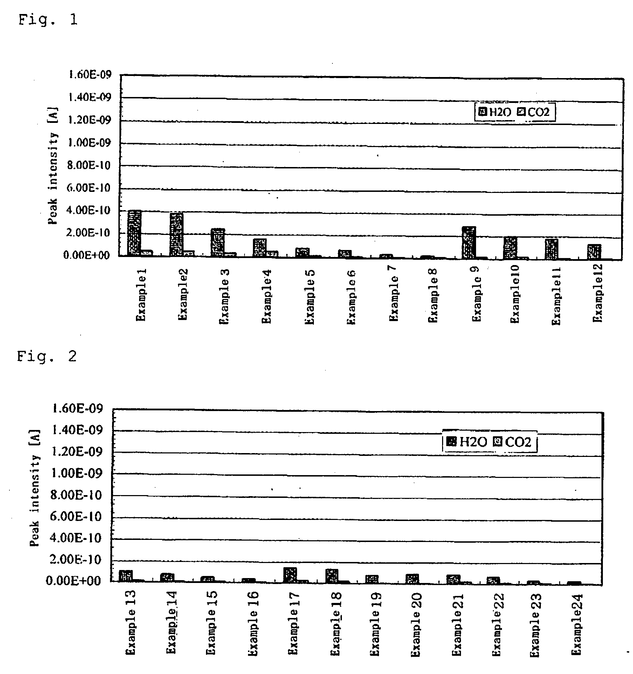

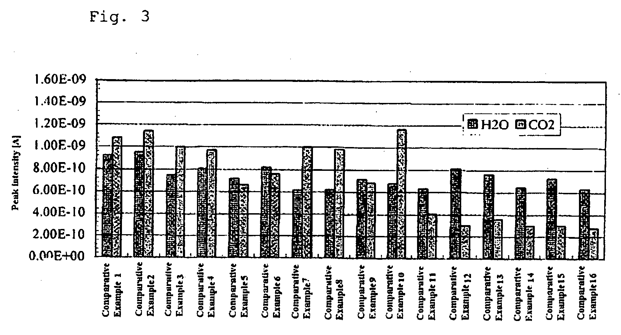

For the measurement of out gas, the temperature was raised from 50°C to 300°C under a degree of vacuum of 1.0 × 10⁻⁷ Pa using TDS-MS (thermal desorption spectroscopy-mass spectrometer) "WA1000SW (manufactured by ESCO, Ltd.)", and then the peak intensities of out gas of water (mass number 18) and carbon dioxide (mass number 44) at 300°C were measured. The results are shown in Figs. 1 to 3 and Table 3.

**[Table 3]**

| | Sensitivity mJ/cm² | Peak intensity at 300°C | |
|---|---|---|---|
| | | Water (mass number 18) | Carbon dioxide (mass number 44) |
| Example 1 | 70 | 3.98E-10 | 7.90E-10 |
| Example 2 | 180 | 3.79E-10 | 4.52E-11 |
| Example 3 | 50 | 2.45E-10 | 3.31E-11 |
| Example 4 | 90 | 1.58E-10 | 4.81E-11 |
| Example 5 | 80 | 7.84E-11 | 9.87E-12 |
| Example 6 | 200 | 6.43E-11 | 7.61E-12 |
| Example 7 | 70 | 3.01E-11 | 5.02E-12 |
| Example 8 | 100 | 1.74E-11 | 5.12E-12 |
| Example 9 | <20 | 2.89E-10 | 1.67E-11 |
| Example 10 | 70 | 1.98E-10 | 2.11E-11 |
| Example 11 | <20 | 1.81E-10 | 9.88E-12 |
| Example 12 | <20 | 1.32E-10 | 4.11E-12 |
| Example 13 | 60 | 9.74E-11 | 1.18E-11 |
| Example 14 | 180 | 7.37E-11 | 8.17E-12 |
| Example 15 | 40 | 4.87E-11 | 9.83E-12 |
| Example 16 | 80 | 3.48E-11 | 4.58E-12 |
| Example 17 | 30 | 1.39E-10 | 2.24E-11 |
| Example 18 | 140 | 1.27E-10 | 1.98E-11 |
| Example 19 | <20 | 7.64E-11 | 3.87E-12 |
| Example 20 | 60 | 8.73E-11 | 4.98E-12 |
| Example 21 | positive | 8.67E-11 | 2.18E-11 |
| Example 22 | positive | 6.43E-11 | 9.87E-12 |
| Example 23 | positive | 3.18E-11 | 8.76E-12 |
| Example 24 | positive | 2.89E-11 | 5.74E-12 |
| Comparative Example 1 | 90 | 9.20E-10 | 1.08E-09 |
| Comparative Example 2 | 120 | 9.48E-10 | 1.14E-09 |
| Comparative Example 3 | 110 | 7.46E-10 | 9.98E-10 |
| Comparative Example 4 | 300 | 8.01E-10 | 9.67E-10 |
| Comparative Example 5 | 70 | 4.61E-10 | 6.58E-11 |
| Comparative Example 6 | 100 | 3.49E-10 | 7.55E-10 |
| Comparative Example 7 | 60 | 6.08E-10 | 9.98E-10 |
| Comparative Example 8 | 100 | 5.94E-10 | 9.80E-10 |
| Comparative Example 9 | 80 | 7.13E-10 | 6.80E-10 |
| Comparative Example 10 | 120 | 6.75E-10 | 1.16E-09 |
| Comparative Example 11 | <20 | 6.32E-10 | 4.02E-10 |
| Comparative Example 12 | 70 | 8.12E-10 | 3.01E-10 |
| Comparative Example 13 | 40 | 7.58E-10 | 3.59E-10 |
| Comparative Example 14 | 80 | 6.42E-10 | 2.98E-10 |
| Comparative Example 15 | <20 | 7.21E-10 | 3.00E-10 |
| Comparative Example 16 | 50 | 6.31E-10 | 2.78E-10 |

## Claims

1. A radiation-sensitive resin composition comprising (A) a novolac resin having repeating units represented by formula (I) given below, (B) at least one thermally-reactive compound selected from the group consisting of benzoxazine compounds, carbodiimide compounds, triazinethiol compounds, and bismaleimide compounds, (C) a radiation-sensitive compound, and (D) a solvent: 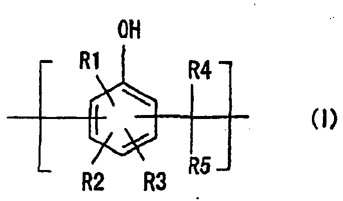 in formula (I), R1 to R3 each independently represent a hydrogen atom, a hydroxyl group, an alkoxyl group having 1 to 2 carbon atoms, or an alkyl group having 1 to 10 carbon atoms, R4 to R5 each independently represent a hydrogen atom, an alkyl group having 1 to 5 carbon atoms, or a phenyl group that may have a halogen atom, a hydroxyl group or an alkyl group having 1 to 5 carbon atoms as a substituent, wherein among all of the repeating units represented by formula (I) in the resin, the plurality of R1s, the plurality of R2s, the plurality of R3s, the plurality of R4s, and the plurality of R5s individually may be the same or different, provided that among all of the repeating units, at least part of the plurality of R4s and the plurality of R5s is a methyl group, a phenyl group, or a hydroxyphenyl group.

2. The radiation-sensitive resin composition according to claim 1, wherein in the novolac resin (A) the proportion of the repeating units in which R4 and/or R5 is a methyl group, a phenyl group, or a hydroxyphenyl group is 20 to 100%.

3. The radiation-sensitive resin composition according to claim 1 or 2, wherein among all of the repeating units of the novolac resin (A) at least part of the plurality of R4s and the plurality of R5s is a phenyl group.

4. The radiation-sensitive resin composition according to any one of claims 1 to 3, wherein the thermally-reactive compound (B) is a triazinethiol compound or a bismaleimide compound.

5. The radiation-sensitive resin composition according to any one of claims 1 to 4, wherein the radiation-sensitive compound (C) is a naphthoquinonediazide sulfonic acid ester.

6. Use of the radiation-sensitive resin composition according to claim 5 for forming an insulating film in an organic electroluminescent element.

7. The radiation-sensitive resin composition according to any one of claims 1 to 4, wherein the radiation-sensitive compound (C) is a photoacid generator that generates an acid by the action of radiation and is selected from onium salts, halogen-containing compounds, diazomethane compounds, sulfone compounds, alkyl(C₁₋₁₂) sulfonic acid esters, haloalkyl(C₁₋₁₂) sulfonic acid esters, arylsulfonic acid esters and iminosulfonate.

8. The radiation-sensitive resin composition according to any one of claims 1 to 5 and 7, further comprising (E) a surfactant and/or (F) a colorant.

9. A method for forming a radiation lithographic pattern comprising: forming a coat by applying the radiation-sensitive resin composition according to any one of claims 1 to 5, 7 and 8 to the surface of a substrate, prebaking the coat, applying radiation to the prebaked coat through a prescribed patterned mask to form a prescribed patterned coat, performing development with a developer, and subjecting the pattern to heat treatment.

10. An organic electroluminescent element comprising a pattern obtainable by the method of claim 9.

## Patentansprüche

1. Eine strahlungsempfindliche Harzzusammensetzung, umfassend (A) ein Novolak-Harz mit sich wiederholenden Einheiten, dargestellt durch die nachstehend angegebene Formel (I), (B) mindestens eine thermisch reaktive Verbindung, ausgewählt aus der Gruppe bestehend aus Benzoxazinverbindungen, Carbodiimidverbindungen, Triazinthiolverbindungen und Bismaleimidverbindungen, (C) eine strahlungsempfindliche Verbindung und (D) ein Lösungsmittel: 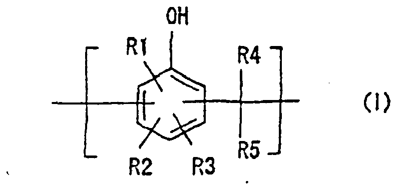 in Formel (I) stehen R1 bis R3 jeweils unabhängig für ein Wasserstoffatom, eine Hydroxygruppe, einen Alkoxyrest mit 1 bis 2 Kohlenstoffatomen oder einen Alkylrest mit 1 bis 10 Kohlenstoffatomen, R4 bis R5 stehen jeweils unabhängig für ein Wasserstoffatom, einen Alkylrest mit 1 bis 5 Kohlenstoffatomen oder einen Phenylrest, der ein Halogenatom, eine Hydroxygruppe oder einen Alkylrest mit 1 bis 5 Kohlenstoffatomen als Substituenten aufweisen kann, wobei unter allen sich wiederholenden Einheiten, dargestellt durch Formel (I) in dem Harz, die Vielzahl von R1, die Vielzahl von R2, die Vielzahl von R3, die Vielzahl von R4 und die Vielzahl von R5 jeweils gleich oder verschieden sein können, mit der Maßgabe, dass unter allen sich wiederholenden Einheiten mindestens ein Teil der Vielzahl von R4 und der Vielzahl von R5 eine Methylgruppe, ein Phenylrest oder ein Hydroxyphenylrest ist.

2. Die strahlungsempfindliche Harzzusammensetzung nach Anspruch 1, wobei in dem Novolak-Harz (A) der Anteil der sich wiederholenden Einheiten, in denen R4 und/oder R5 eine Methylgruppe, ein Phenylrest oder ein Hydroxyphenylrest ist, 20 bis 100% beträgt.

3. Die strahlungsempfindliche Harzzusammensetzung nach Anspruch 1 oder 2, wobei unter allen sich wiederholenden Einheiten des Novolak-Harzes (A) mindestens ein Teil der Vielzahl von R4 und der Vielzahl von R5 ein Phenylrest ist.

4. Die strahlungsempfindliche Harzzusammensetzung nach einem der Ansprüche 1 bis 3, wobei die thermisch reaktive Verbindung (B) eine Triazinthiolverbindung oder eine Bismaleimidverbindung ist.

5. Die strahlungsempfindliche Harzzusammensetzung nach einem der Ansprüche 1 bis 4, wobei die strahlungsempfindliche Verbindung (C) ein Naphthochinondiazidsulfonsäureester ist.

6. Verwendung der strahlungsempfindlichen Harzzusammensetzung nach Anspruch 5 zum Bilden eines Isolierfilms in einem organischen Elektrolumineszenzelement.

7. Die strahlungsempfindliche Harzzusammensetzung nach einem der Ansprüche 1 bis 4, wobei die strahlungsempfindliche Verbindung (C) ein Photosäurebildner ist, der durch Einwirkung von Strahlung eine Säure bildet und aus Oniumsalzen, halogenhaltigen Verbindungen, Diazomethanverbindungen, Sulfonverbindungen, Alkyl(C₁₋₁₂)sulfonsäureestern, Halogenalkyl(C₁₋₁₂)sulfonsäureestern, Arylsulfonsäureestern und Iminosulfonat ausgewählt ist.

8. Die strahlungsempfindliche Harzzusammensetzung nach einem der Ansprüche 1 bis 5 und 7, weiter umfassend (E) ein grenzflächenaktives Mittel und/oder (F) ein Farbmittel.

9. Ein Verfahren zum Bilden eines lithographischen Musters durch Strahlung, umfassend: Bilden einer Schicht durch Auftragen der strahlungsempfindlichen Harzzusammensetzung nach einem der Ansprüche 1 bis 5, 7 und 8 auf die Oberfläche eines Substrats, Prebaking der Schicht, Anwendung von Strahlung auf die prebaked Schicht durch eine vorgegebene mit einem Muster versehene Maske, um eine vorgegebene mit einem Muster versehene Schicht zu bilden, Durchführen von Entwicklung mit einem Entwickler und Unterziehen des Musters einer Wärmebehandlung.

10. Ein organisches Elektrolumineszenzelement, umfassend ein Muster, erhältlich durch das Verfahren nach Anspruch 9.

## Revendications

1. Composition de résine sensible aux rayonnements comprenant (A) une résine novolaque ayant des unités répétées représentées par la formule (I) donnée ci-dessous, (B) au moins un composé thermiquement réactif choisi dans le groupe consistant en les composés de benzoxazine, les composés de carbodiimide, les composés de triazinethiol et les composés de bismaléimide, (C) un composé sensible aux rayonnements et (D) un solvant : 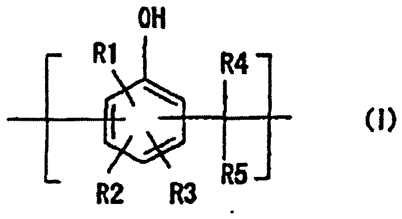 dans la formule (I), R1 à R3 représentent chacun indépendamment un atome d'hydrogène, un groupe hydroxyle, un groupe alcoxyle ayant 1 à 2 atomes de carbone ou un groupe alkyle ayant 1 à 10 atomes de carbone, R4 à R5 représentent chacun indépendamment un atome d'hydrogène, un groupe alkyle ayant 1 à 5 atomes de carbone ou un groupe phényle qui peut avoir un atome d'halogène, un groupe hydroxyle ou un groupe alkyle ayant 1 à 5 atomes de carbone comme substituant, où parmi toutes les unités répétées représentées par la formule (I) dans la résine, la pluralité de R1, la pluralité de R2, la pluralité de R3, la pluralité de R4 et la pluralité de R5 peuvent être individuellement identiques ou différents, à condition que parmi toutes les unités répétées, au moins une partie de la pluralité de R4 et de la pluralité de R5 soit un groupe méthyle, un groupe phényle ou un groupe hydroxyphényle.

2. Composition de résine sensible aux rayonnements selon la revendication 1 où, dans la résine novolaque (A), la proportion des unités répétées dans lesquelles R4 et/ou R5 est un groupe méthyle, un groupe phényle ou un groupe hydroxyphényle est 20 à 100 %.

3. Composition de résine sensible aux rayonnements selon la revendication 1 ou 2, où parmi toutes les unités répétées de la résine novolaque (A) au moins une partie de la pluralité de R4 et de la pluralité de R5 est un groupe phényle.

4. Composition de résine sensible aux rayonnements selon l'une quelconque des revendications 1 à 3, où le composé thermiquement réactif (B) est un composé de triazinethiol ou un composé de bismaléimide.

5. Composition de résine sensible aux rayonnements selon l'une quelconque des revendications 1 à 4, où le composé sensible aux rayonnements (C) est un ester d'acide naphtoquinonediazidesulfonique.

6. Utilisation de la composition de résine sensible aux rayonnements selon la revendication 5 pour former un film isolant dans un élément électroluminescent organique.

7. Composition de résine sensible aux rayonnements selon l'une quelconque des revendications 1 à 4, où le composé sensible aux rayonnements (C) est un photogénérateur d'acide qui génère un acide par l'action d'un rayonnement et qui est choisi parmi les sels d'onium, les composés halogénés, les composés de diazométhane, les composés de sulfone, les esters d'acides alkyl(C₁₋₁₂)sulfoniques, les esters d'acides haloalkyl(C₁₋₁₂)sulfoniques, les esters d'acides arylsulfoniques et l'iminosulfonate.

8. Composition de résine sensible aux rayonnements selon l'une quelconque des revendications 1 à 5 et 7, comprenant en outre (E) un tensioactif et/ou (F) un colorant.

9. Procédé pour former un motif lithographique par rayonnement comprenant : la formation d'un revêtement par application de la composition de résine sensible aux rayonnements selon l'une quelconque des revendications 1 à 5, 7 et 8 à la surface d'un substrat, la précuisson du revêtement, l'application d'un rayonnement au revêtement précuit au travers d'un masque muni d'un motif prescrit pour former un revêtement muni d'un motif prescrit, la mise en oeuvre d'un développement avec un agent de développement et l'exposition du motif à un traitement thermique.

10. Elément électroluminescent organique comprenant un motif pouvant être obtenu par le procédé selon la revendication 9.
